# FASCICULE DE BREVET EUROPEEN

(11) **EP 1 433 203 B1**
(45) Date de publication et mention de la délivrance du brevet: **15.08.2018**
(21) Numéro de dépôt: 02783186.6
(22) Date de dépôt: 20.09.2002
(51) Int. Cl.: H01L 21/48, H01L 23/48, G01P 15/08

(54) **PROCÉDÉ DE RÉALISATION D'UNE PRISE DE CONTACT EN FACE ARRIERE D'UN COMPOSANT À SUBSTRATS EMPILES**
HERSTELLUNGSVERFAHREN EINES RÜCKSEITENKONTAKTES AUF EIN BAUTEIL MIT GESTAPELTEN SUBSTRATEN
METHOD OF PRODUCING A CONTACT SYSTEM ON THE REAR OF A COMPONENT WITH STACKED SUBSTRATES AND A COMPONENT EQUIPPED WITH ONE SUCH CONTACT SYSTEM

(30) Priorité: 24.09.2001 FR 0112263
(43) Date de publication de la demande: 30.06.2004
(73) Titulaire: Commissariat à l'Énergie Atomique et aux Énergies Alternatives, 75015 Paris (FR)
(72) Inventeur: DANEL, Jean-Sébastien, 38130 Echirolles (FR)
(74) Mandataire: Ahner, Philippe
(86) Numéro de dépôt international: PCT/FR2002/003225
(87) Numéro de publication internationale: WO 2003/028101

(56) Documents cités:
- EP-A- 0 611 967
- DE-A- 19 962 231
- FR-A- 2 754 386
- US-A- 5 987 989
- US-A- 6 065 341
- US-B1- 6 338 284

## Description

### Domaine technique

La présente invention concerne un procédé de réalisation d'une prise de contact en face arrière d'un composant à substrats empilés. Elle concerne également un composant équipé d'une telle prise de contact.

L'invention concerne en particulier des composants comprenant un capteur ou une partie sensible quelconque sur une première face libre. La face arrière est définie comme étant la face opposée à la face libre pourvue du capteur ou de la partie sensible. Elle est destinée notamment à l'interconnexion du composant avec d'autres composants d'un circuit, pour son alimentation électrique et/ou pour l'échange de signaux.

L'invention trouve notamment des applications au conditionnement et à la protection de composants à capteurs tels que, par exemple, les accéléromètres ou les capteurs de pression. Elle trouve des applications également à d'autres composants présentant un organe sensible, tels que les gyromètres, ou les résonateurs.

### Etat de la technique antérieure.

Les composants pourvus de capteurs présentent en général un substrat avec une face libre susceptible d'être en contact avec un milieu donné pour la saisie de grandeurs physiques, ou chimiques. La face libre est ainsi susceptible d'être mise en contact avec un milieu qui peut s'avérer incompatible avec la présence, sur la même face, de bornes électriques. Le milieu peut être chimiquement agressif pour les bornes ou d'autres parties du composant. Le milieu peut aussi être conducteur de l'électricité et fausser les mesures, ou créer un court-circuit.

Pour ces raisons, les bornes électriques sont généralement reportées sur une face arrière du substrat, cette face étant protégée, si nécessaire, par un conditionnement approprié. En particulier, un premier substrat, comprenant le capteur, peut être associé à un deuxième substrat collé sur sa face arrière de façon à protéger les bornes. Le deuxième substrat peut aussi servir à protéger le capteur. Le deuxième substrat peut encore comporter une partie du capteur, ou comporter un circuit électronique associé au capteur.

Afin de réaliser une prise de contact sur les bornes de la face arrière du premier substrat, il est connu de pratiquer des trous d'accès à travers le deuxième substrat à l'aplomb de ces bornes, et de métalliser les trous.

L'encombrement des trous, nécessairement assez larges, n'est pas compatible avec une densité élevée de bornes d'entrée-sortie. De plus, les trous confèrent à la face arrière du deuxième substrat un relief peu approprié à des étapes ultérieures de fabrication de pistes conductrices ou d'autres composants. Enfin des problèmes de remplissage des trous ou des problèmes de rebouchage peuvent apparaître lors de leur métallisation. La métallisation des trous peut également poser des problèmes de fiabilité lorsque le composant doit subir des traitements thermiques à température élevée lors d'étapes de procédé subséquentes. US 5987989 décrit un capteur semiconducteur pour détecter une quantité physique, et au procédé de fabrication de ce capteur.

### Exposé de l'invention

La présente invention a pour but de proposer un procédé ne présentant pas les limitations ou problèmes évoqués ci-dessus.

Un but est en particulier de proposer un procédé permettant de garantir une excellente protection d'un composant contre toute agression chimique, ou mécanique. Le but est aussi de garantir une prise de contact fiable sur ses bornes.

Un autre but est de faciliter le report des contacts électriques sur une face arrière du composant et de permettre une connexion de densité élevée.

L'invention a également pour but de proposer un composant à substrat multiple, avec au moins une prise de contact en face arrière, et présentant une face arrière plane.

Pour atteindre ces buts l'invention a plus précisément pour objet un procédé de réalisation d'une prise de contact en face arrière d'un composant comprenant au moins un premier substrat avec au moins une région active, et au moins un deuxième substrat, servant de protection de la région active. Conformément à l'invention, on utilise un deuxième substrat non-isolant et on y pratique au moins une barrière d'isolation traversante entourant une partie de ce substrat, la barrière étant localisée de façon que ladite partie du substrat soit en contact avec la région active lorsque les premier et deuxième substrats sont assemblés.

La barrière d'isolation peut être constituée par un joint isolant quelconque qui entoure une partie du deuxième substrat. Elle peut notamment être constituée par une tranchée, garnie ou non de matériau isolant.

Dans la description qui suit, on considère que la ou les barrières isolantes sont formées par des tranchées.

On entend, au sens de l'invention, par « région active » toute partie d'un composant susceptible d'être associée dans son fonctionnement à une prise de contact et/ou à une borne électrique de connexion. La région active peut être, par exemple, une partie de couche conductrice, une armature de condensateur, une électrode, ou une partie de transistor. La région active peut aussi former une chambre d'un capteur de pression.

Par ailleurs, on désigne par "non isolant" un matériau conducteur, semi-conducteur ou électriquement résistif, susceptible de conduire des charges électriques. Le substrat est considéré comme comprenant une ou plusieurs couches en de tels matériaux.

La partie du substrat entourée par la tranchée isolante constitue un pilier qui traverse de part en part le substrat et qui reporte le contact pris sur la région active vers une face arrière du dispositif qui se trouve être la face libre du deuxième substrat.

Le pilier est conducteur de l'électricité dans la mesure où il est simplement délimité dans le deuxième substrat en matériau non-isolant.

Le pilier présente également l'avantage de posséder une extrémité libre située exactement dans le plan de la face arrière, c'est-à-dire la face libre du deuxième substrat. Cette caractéristique facilite grandement la réalisation ultérieure de pistes d'interconnexion pour relier entre eux différents piliers ou pour les relier à d'autres composants ou bornes.

De plus, la réalisation d'une prise de contact telle que décrite ci-dessus ne nécessite pas la formation de puits de contact à travers un deuxième substrat isolant. Elle élimine ainsi les difficultés de remplissage de ces puits avec un matériau électriquement conducteur.

Enfin, le pilier délimité dans la masse du deuxième substrat est particulièrement insensible à d'éventuels traitements thermiques susceptibles d'être associés à des étapes subséquentes d'achèvement du composant.

La tranchée d'isolation du pilier peut, dans un cas qui ne fait pas partie de la présente invention, être pratiquée dans le deuxième substrat après assemblage de celui-ci avec le premier substrat. Dans ce cas, la gravure du deuxième substrat peut avoir lieu avec arrêt sur le premier substrat, éventuellement pourvu d'une couche d'arrêt de gravure prévue à cet effet, par exemple, une couche en aluminium ou en chrome.

Toutefois, selon la méthode de l'invention, plus facile à mettre en oeuvre, la tranchée peut être pratiquée dans le deuxième substrat avant l'assemblage.

La tranchée ou les tranchées peuvent être gravées dans le deuxième substrat par l'une des faces ou par les deux faces.

Il est possible, par exemple, de pratiquer d'abord une tranchée non traversante depuis une première face du deuxième substrat puis de procéder à un amincissement du substrat depuis la deuxième face jusqu'à ouvrir la tranchée.

Les techniques susceptibles d'être mises en oeuvre pour la gravure des tranchées, mais aussi leur remplissage sont en soi connues. On peut se reporter à ce sujet au document (1) dont la référence est précisée en fin de description.

Comme évoqué ci-dessus, la ou les tranchées peuvent être garnies d'un matériau isolant électrique. Elles peuvent aussi être conservées vides ou, plus précisément, emplies d'air.

La garniture partielle ou complète des tranchées peut avoir lieu, par exemple, par oxydation thermique de leurs flancs, par dépôt d'oxyde, par association d'une chemise d'oxyde recouvrant les flancs de tranchée et d'un coeur en polysilicium, ou encore, au moyen d'un verre isolant que l'on fait fondre dans les tranchées.

Selon un perfectionnement de l'invention, on peut encore procéder à une passivation d'une face du premier substrat destinée à venir en contact avec le deuxième substrat, et former un pavé de contact relié électriquement à la région active, et affleurant sur ladite face. De la même façon, on peut aussi procéder à une passivation d'une face du deuxième substrat destinée à venir en contact avec le premier substrat et former un pavé de contact relié électriquement à la partie du deuxième substrat entourée par la tranchée, c'est-à-dire le pilier évoqué ci-dessus. Ce pavé affleure alors à ladite face du deuxième substrat.

L'utilisation de pavés de contact permet de recourir à des matériaux présentant une bonne conductivité, dans la zone de contact entre le pilier et la région active.

Le choix des matériaux des pavés peut aussi être dicté par l'exigence d'un contact mécanique et électrique de bonne qualité. En particulier, la région active et/ou le pilier peuvent être pourvus de pavés de contact en des matériaux différents, susceptibles de s'allier. Dans ce cas, les pavés peuvent être en contact par l'intermédiaire d'une couche d'alliage formée à partir de ces matériaux.

Tel est le cas par exemple lorsqu'on utilise un pavé de titane sur le premier substrat, en contact avec la région active et lorsque le pavé est reporté contre un pilier de contact en silicium du deuxième substrat. Lors de l'assemblage des premier et deuxième substrats un traitement thermique peut être mis en oeuvre pour provoquer la formation d'un siliciure de titane à l'interface pilier-pavé.

L'invention concerne également un composant selon la revendication 8. Conformément à l'invention, le deuxième substrat comporte au moins un pilier en un matériau conducteur électrique, électriquement isolé d'une partie restante du deuxième substrat, en contact électrique avec la région active, et traversant de part en part le deuxième substrat. La prise de contact est formée par l'extrémité du pilier affleurant sur la face arrière du composant, c'est-à-dire sur une face libre du deuxième substrat.

D'autres caractéristiques et avantages de l'invention ressortiront de la description qui va suivre, en référence aux figures des dessins annexés. Cette description est donnée à titre purement illustratif et non limitatif.

### Brève description des figures

La figure 1 est une coupe schématique de deux substrats et montre leur assemblage en vue de la formation d'un composant conforme à l'invention.
La figure 2 est une coupe schématique d'un autre assemblage de substrats pour la réalisation d'un composant conforme à l'invention.
La figure 3 est une coupe schématique d'un composant, également conforme à l'invention.

### Description détaillée de modes de mise en oeuvre de l'invention.

Dans la description qui suit, des parties identiques, similaires ou équivalentes des différentes figures sont repérées par les mêmes signes de référence pour en faciliter la lecture. Par ailleurs, et dans un souci de clarté des figures, tous les éléments ne sont pas représentés selon une échelle uniforme.

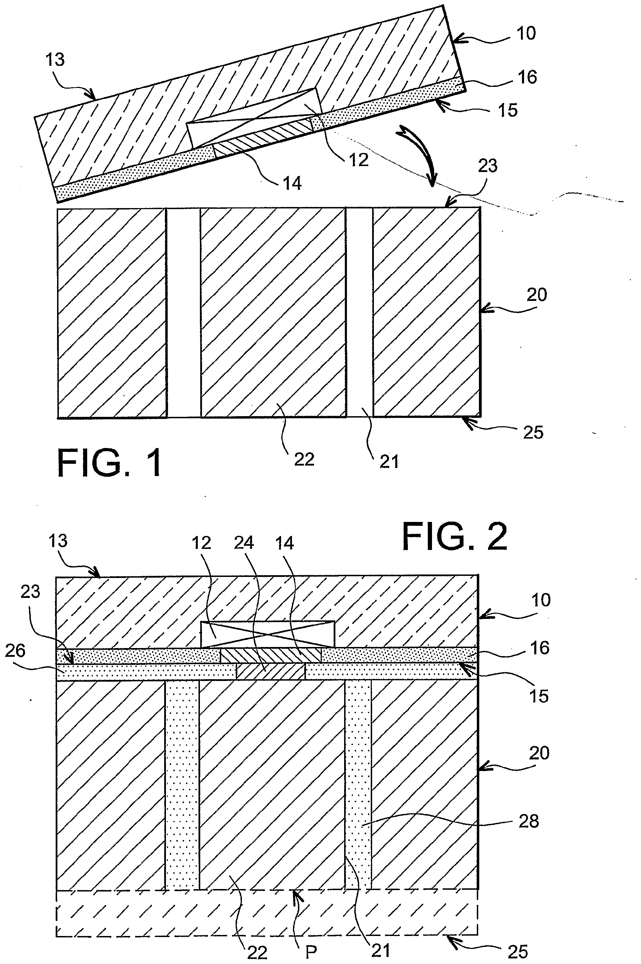

La figure 1 montre un premier substrat 10 qui comporte une région active 12. Celle-ci constitue, par exemple, une partie d'un capteur tel qu'un accéléromètre.

La région active est associée à un pavé de contact 14 qui constitue une borne électrique. Il s'agit, par exemple, d'une borne reliée à l'armature d'un condensateur électrique utilisé pour la détection d'une accélération.

Le pavé de 14 est incrusté dans une couche de passivation 16 formée sur une face arrière 15 du premier substrat 10. Le pavé 14 est, par exemple, en un métal ou en silicium polycristallin. Il est déposé de façon conforme dans une ouverture pratiquée dans la couche de passivation 16, et est en contact électrique avec la région active. Un éventuel planage de la face arrière 15 permet de rendre la surface de la couche de passivation, et celle du pavé, parfaitement coplanaires.

La couche de passivation, en un matériau isolant électrique, tel que, par exemple, de l'oxyde de silicium, permet de protéger la face arrière du composant, et notamment la région active, d'une éventuelle agression de l'environnement. Elle permet aussi de fournir une isolation électrique pour éviter tout court circuit entre différentes parties du premier substrat lorsqu'il est mis en contact avec le deuxième substrat. Lorsque le premier substrat 10 n'est pas isolant, la couche de passivation évite encore qu'il ne relie électriquement le pilier à la partie restante du deuxième substrat.

On peut noter que, selon les applications envisagées, la région active, ou tout au moins le dispositif dont elle fait partie, peuvent s'étendre jusque sur la face libre 13 du premier substrat 10 qui est ici la face opposée à la face arrière 15 portant la couche de passivation 16. Ceci est, par exemple, le cas de capteurs qui doivent présenter une surface de contact avec le milieu sur lequel portent les mesures à effectuer.

Un deuxième substrat 20 en un matériau non isolant est fourni. Il s'agit, par exemple d'un substrat de silicium. L'une des fonctions de ce substrat est de protéger la face arrière 15 du premier substrat 10 et notamment le pavé de contact et /ou la région active qui y affleurent. Le deuxième substrat 20 est également utilisé comme un moyen de câblage électrique pour ramener un ou plusieurs contacts électriques sur la face arrière du composant fini.

Une tranchée 21 pratiquée dans le substrat permet d'y délimiter un pilier 22 qui s'étend de part en part à travers le substrat. Plus précisément, le pilier s'étend depuis une face de report 23 qui est destinée à venir en contact avec le premier substrat jusqu'à une face opposée libre 25, également désignée par « face arrière ».

La tranchée a essentiellement pour fonction de fournir une isolation électrique du pilier. Elle peut être remplie d'air. Elle peut aussi être remplie entièrement, ou en partie seulement, d'un matériau isolant électrique.

Comme cela apparaît encore plus loin dans la description, la tranchée 21 est d'abord pratiquée dans le deuxième substrat, depuis sa face de report, sans entièrement traverser le substrat. Ceci permet de maintenir en place le pilier 22 jusqu'à ce que les premier et deuxième substrats soient rendus solidaires. A ce moment une abrasion de la face libre du deuxième substrat permet d'ouvrir la tranchée. Le pilier est alors maintenu par le premier substrat.

La largeur de la tranchée peut être établie en fonction de l'épaisseur du substrat. Elle est comprise, par exemple, entre un dixième et un cinquantième de l'épaisseur du substrat. A titre d'illustration, pour un substrat d'une épaisseur de 500 µm, on peut pratiquer des tranchées de 50 µm de large.

Sur la figure 1, une flèche indique le report du premier substrat sur le deuxième. Les substrats sont rendus solidaires en les reportant l'un sur l'autre de façon à mettre en contact la face arrière 15 du premier substrat et la face de report 23 du deuxième substrat et de façon à faire coïncider le pilier 22 avec le pavé de contact 14, c'est-à-dire avec la région active. Lorsque la région active présente elle-même une partie conductrice affleurante, le pavé de contact 14 peut éventuellement être omis.

Le scellement entre les premier et deuxième substrats peut être un scellement direct par adhésion moléculaire. Il peut aussi faire appel à une colle intermédiaire.

On peut noter que la face libre 13, 25 de l'un au moins des substrats, peut être solidaire d'un substrat formant poignée (non représenté) jusqu'à ce que les premier et deuxième substrats soient solidaires. La face est ensuite rendue libre en détachant le substrat considéré du substrat formant poignée.

La figure 2 montre un composant conforme à l'invention, dont la fabrication n'est pas entièrement achevée mais dont les premier et deuxième substrats 10, 20 sont déjà assemblés.

A l'instar du premier substrat de la figure 1, le premier substrat 10 de la figure 2 comprend une couche de passivation 16 dans laquelle un pavé conducteur est incrusté. Le pavé 14 est en contact avec une région active 12 représentée de façon symbolique.

Contrairement au deuxième substrat 20 de la figure 1, le deuxième substrat 20 de la figure 2 présente sur sa face de report 23 une couche de passivation 26. Il s'agit d'une couche d'isolant électrique. De préférence, lorsque le deuxième substrat est en silicium, la couche de passivation 26 peut être une couche de SiO₂.

La couche de passivation présente une ouverture correspondant au pilier conducteur 22. Dans cette ouverture est incrusté un pavé de contact 24. Il s'agit d'un pavé comparable au pavé de contact 14 du premier substrat, en un matériau électriquement conducteur (métal, poly-Si). Il affleure à la surface de la couche de passivation 26.

Lors de l'assemblage des substrats, le pavé 14 du premier substrat 10 est mis en contact avec le pavé 24 du deuxième substrat 20. Ils forment ainsi un lien électrique entre la région active et le pilier 22. En dehors des pavés de contact, les couches de passivation 16 et 26 des deux substrats sont également en contact. Ceci permet de garantir une meilleure isolation électrique entre les deux substrats, en dehors du contact pilier-région active.

Comme indiqué précédemment, et conformément à un choix particulier, les pavés de contact peuvent être réalisés en des matériaux susceptibles de s'allier facilement lorsqu'ils sont mis en contact. Ceci est le cas, par exemple, pour des couples de matériaux tels que Si et Ti ou Si et Pd.

On peut observer sur la figure 2 que la tranchée 21 contient un matériau isolant 28. Il s'agit, par exemple d'un verre isolant, ou d'un oxyde formé par dépôt chimique en phase vapeur, qui emplit de façon conforme la tranchée. A titre d'alternative, la tranchée peut aussi être tapissée d'une couche d'oxyde thermique puis comblée d'un matériau qui n'est pas nécessairement isolant, tel que le silicium polycristallin.

La tranchée 21 du deuxième substrat est gravée depuis la face de report 23, et perpendiculairement à cette face, jusqu'à une profondeur correspondant aux 2/3 ou aux 3/4 de l'épaisseur totale du deuxième substrat. La gravure, de même que le garnissage de la tranchée ont lieu avant l'assemblage des substrats.

Après l'assemblage, c'est-à-dire après l'obtention d'un composant conforme à la figure 2, on procède à un planage de la face arrière libre 25, par exemple par abrasion mécano-chimique, jusqu'à mettre à jour la tranchée et l'extrémité du pilier qui forme une prise de contact P. L'opération d'abrasion a aussi pour fonction de parachever l'isolation électrique du pilier de contact 22.

La partie du deuxième substrat éliminée lors de l'abrasion est représentée en trait discontinu.

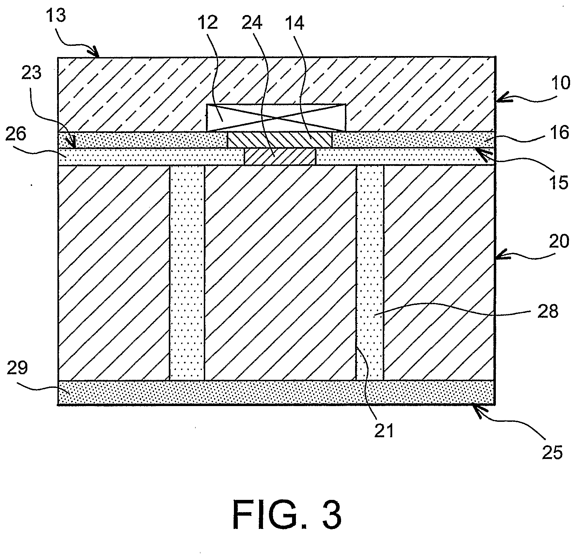

La figure 3, montre le composant de la figure 2 après l'opération de planage, et après la formation sur la face arrière 25 d'une couche de passivation 29 en un matériau isolant électrique. Une ouverture (non représentée) peut être pratiquée dans la couche de passivation 29 pour prendre contact sur le pilier. En outre, le caractère plan de la face arrière du composant se prête bien à la mise en oeuvre d'autres opérations de lithographie, pour la formation, par exemple, de pistes d'interconnexions.

Dans la description qui précède, il est fait référence, pour des raisons de simplification, à un pilier unique qui vient en contact avec une région active unique. Toutefois, l'invention peut être mise en oeuvre en associant à une pluralité de régions actives, une pluralité de piliers, tous isolés les uns des autres.

### DOCUMENT CITE

(1) FR-A-2 754 386

## Revendications

1. Procédé de réalisation d'une prise de contact (P) en face arrière (25) d'un composant, ledit composant comprenant :
- au moins un premier substrat (10) avec au moins une région active (12), et
- au moins un deuxième substrat (20) de protection de la région active,
ledit procédé étant **caractérisé en ce que** l'on utilise un deuxième substrat en un matériau non-isolant, on y pratique au moins une barrière (21) d'isolation traversante, entourant une partie (22) de ce deuxième substrat et isolant électriquement cette partie, de façon que ladite partie (22) du deuxième substrat soit en contact avec la région active (12) lorsque les premier et deuxième substrats sont assemblés, on pratique dans le deuxième substrat au moins une tranchée traversante (21) formant la barrière d'isolation, et l'on pratique la tranchée (1) avant l'assemblage des premier et deuxième substrats.

2. Procédé selon la revendication 1, dans lequel, avant l'assemblage, on procède à une passivation d'une face (15) du premier substrat destinée à venir en contact avec le deuxième substrat et on forme un pavé de contact (14) relié électriquement à la région active, et affleurant sur ladite face (15).

3. Procédé selon la revendication 1, dans lequel, avant l'assemblage, on procède à une passivation d'une face (23) du deuxième substrat destinée à venir en contact avec le premier substrat et on forme un pavé (24) de contact relié électriquement à la partie du deuxième substrat entourée par la tranchée, et affleurant sur ladite face du deuxième substrat.

4. Procédé selon la revendication 1, dans lequel on garnit la tranchée (21) avec un matériau isolant électrique (28).

5. Procédé selon la revendication 1, dans lequel on pratique la tranchée traversante par une gravure depuis deux faces opposées du deuxième substrat.

6. Procédé selon la revendication 1, dans lequel on pratique la tranchée traversante par gravure depuis une seule face du deuxième substrat.

7. Procédé selon la revendication 6, dans lequel on pratique une tranchée non traversante depuis une face du deuxième substrat et l'on effectue un amincissement du deuxième substrat depuis une face opposée jusqu'à l'ouverture de la tranchée.

8. Composant obtenu par le procédé selon la revendication 1, ce composant comprenant un premier substrat (10) avec au moins une région active et un deuxième substrat (20), solidaire du premier substrat, et recouvrant la région active, dans lequel le deuxième substrat comporte au moins un pilier (22) en un matériau conducteur électrique, électriquement isolé d'une partie restante du substrat, le pilier (22) étant en contact électrique avec la région active, et traversant de part en part le deuxième substrat, et dans lequel la région active et/ou le pilier sont pourvus de pavés de contact (14, 24) en des matériaux électriquement conducteurs différents, susceptibles de s'allier, les pavés étant en contact par l'intermédiaire d'une couche d'alliage de ces matériaux.

## Patentansprüche

1. Verfahren zur Herstellung einer Kontaktstelle (P) an der Rückseite (25) eines Bauteils, wobei das Bauteil umfasst:
- wenigstens ein erstes Substrat (10) mit wenigstens einer aktiven Region (12), und
- wenigstens ein zweites Substrat (20) zum Schutz der aktiven Region,
wobei das Verfahren **dadurch gekennzeichnet ist, dass** man ein zweites Substrat aus einem nicht-isolierenden Material verwendet, man dort wenigstens eine durchgehende Isolationsbarriere (21) vorsieht, die einen Teil (22) dieses zweiten Substrats umgibt und diesen Teil elektrisch isoliert, derart, dass der Teil (22) des zweiten Substrats in Kontakt mit der aktiven Region (12) ist, wenn das erste und das zweite Substrat zusammengefügt werden, man in dem zweiten Substrat wenigstens einen durchgehenden Graben (21) herstellt, der die Isolationsbarriere bildet, und man den Graben (1) vor dem Zusammenfügen des ersten und des zweiten Substrats herstellt.

2. Verfahren nach Anspruch 1, wobei man vor dem Zusammenfügen eine Passivierung einer Fläche (15) des ersten Substrats vornimmt, die dazu ausgelegt ist, in Kontakt mit dem zweiten Substrat zu gelangen, und man einen Kontaktblock (14) bildet, der elektrisch mit der aktiven Region verbunden ist und mit dieser Fläche (15) fluchtet.

3. Verfahren nach Anspruch 1, wobei man vor dem Zusammenfügen eine Passivierung einer Fläche (23) des zweiten Substrats vornimmt, die dazu ausgelegt ist, in Kontakt mit dem ersten Substrat zu gelangen, und man einen Kontaktblock (24) bildet, der elektrisch mit dem Teil des zweiten Substrats verbunden ist, der durch den Graben umgeben ist, und mit der Fläche des zweiten Substrats fluchtet.

4. Verfahren nach Anspruch 1, wobei man den Graben (21) mit einem elektrisch isolierenden Material (28) versieht.

5. Verfahren nach Anspruch 1, wobei man den durchgehenden Graben durch eine Ätzung ausgehend von zwei entgegengesetzten Flächen des zweiten Substrats herstellt.

6. Verfahren nach Anspruch 1, wobei man den durchgehenden Graben durch eine Ätzung ausgehend von einer einzigen Fläche des zweiten Substrats herstellt.

7. Verfahren nach Anspruch 6, wobei man einen nicht durchgehenden Graben ausgehend von einer Fläche des zweiten Substrats herstellt, und man eine Abdünnung des zweiten Substrats ausgehend von einer entgegengesetzten Fläche bis zur Öffnung des Grabens durchführt.

8. Bauteil, das durch das Verfahren nach Anspruch 1 erhalten ist, wobei dieses Bauteil ein erstes Substrat (10) umfasst mit wenigstens einer aktiven Region, und ein zweites Substrat (20), das mit dem ersten Substrat verbunden ist und die aktive Region bedeckt, wobei das zweite Substrat wenigstens einen Pfeiler (22) aus einem elektrisch leitenden Material umfasst, der elektrisch von einem übrigen Teil des Substrats isoliert ist, wobei der Pfeiler (22) in elektrischem Kontakt mit der aktiven Region ist und das zweite Substrat vollständig durchsetzt, und wobei die aktive Region und/oder der Pfeiler mit Kontaktblöcken (14, 24) aus verschiedenen elektrisch leitenden Materialien versehen sind, die dazu ausgelegt sind, sich miteinander zu legieren, wobei die Blöcke mittels einer Legierungsschicht dieser Materialien in Kontakt miteinander sind.

## Claims

1. Process for making a contact point (P) on the rear surface of a component including at least one first substrate (10) with at least one active region (12), and at least one second substrate (20) protecting the active region, **characterised in that** a second substrate of non-insulating material is used, in it is made at least one through insulation barrier (21), surrounding one part of this second substrate and electrically insulating said part, in such a way that said part of the second substrate is in contact with the active region when the first and second substrates are assembled, at least one through trench (21) forming the insulation barrier is made in the second substrate, and the trench (1) is made prior to the assembly of the first and second substrates.

2. Process according to claim 1, wherein, prior to assembly, a passivation is carried out of one surface (15) of the first substrate intended to come into contact with the second substrate and a contact block (14) is formed electrically connected to the active region, and flush with said surface (15).

3. Process according to claim 1, wherein, prior to assembly, a passivation is carried out of one surface (23) of the second substrate intended to come into contact with the first substrate and a contact block (24) is formed electrically connected to the part of the second substrate surrounded by the trench, and flush with said surface of the second substrate.

4. Process according to claim 1, wherein the trench (21) is lined with an electrically insulating material (28).

5. Process according to claim 1, wherein the through trench is made by etching from two opposite surfaces of the second substrate.

6. Process according to claim 1, wherein the through trench is made by etching from a single surface of the second substrate.

7. Process according to claim 6, wherein a trench which does not pass right through is made from one surface of the second substrate and the second substrate is thinned down from an opposite surface until the trench is opened up.

8. Component obtained by the process according to claim 1, said component including a first substrate (10) with at least one active region and a second substrate (20), integral with the first substrate, and covering the active region, wherein the second substrate comprises at least one pillar (22) made of an electrically conductive material, electrically insulated from a remaining part of the substrate, the pillar (22) being in electrical contact with the active region, and passing right through the second substrate, and the active region and/or the pillar are provided with contact blocks (14, 24) made of different electrically conductive materials able to alloy together, the blacks being in contact by means of a layer of alloy of these materials.
